# EUROPÄISCHE PATENTSCHRIFT

(11) **EP 3 354 120 B1**
(45) Veröffentlichungstag und Bekanntmachung des Hinweises auf die Patenterteilung: **09.10.2019**
(21) Anmeldenummer: 16758141.2
(22) Anmeldetag: 25.08.2016
(51) Int. Cl.: H05K 7/20

(54) **VORRICHTUNG MIT EINEM ROHRKÜHLER UND EINEM ELEKTRONIKGEHÄUSE**
DEVICE COMPRISING A TUBULAR COOLER AND AN ELECTRONIC HOUSING
DISPOSITIF MUNI D'UN REFROIDISSEUR TUBULAIRE ET D'UN BOÎTIER ÉLECTRONIQUE

(30) Priorität: 23.09.2015 DE 102015218303
(43) Veröffentlichungstag der Anmeldung: 01.08.2018
(73) Patentinhaber: Continental Automotive GmbH, 30165 Hannover (DE)
(72) Erfinder: KERNER, Nikolaus, 93173 Wenzenbach (DE)
(86) Internationale Anmeldenummer: PCT/EP2016/070069
(87) Internationale Veröffentlichungsnummer: WO 2017/050519

(56) Entgegenhaltungen:
- WO-A1-2004/085209
- WO-A1-2015/037824
- DE-A1-102005 036 299
- US-A1- 2001 036 061

## Beschreibung

Die Erfindung betrifft einen Rohrkühler und eine Vorrichtung mit einem Rohrkühler und einem Elektronikgehäuse.

Aus der US 6,016,251 sind eine Leiterplatte und eine Kühlvorrichtung zur Kühlung der Leiterplatte bekannt.

Die DE 10 2005 036299 A1 betrifft ein flüssigkeitsdurchströmtes Kühlsystem zum Abführen von Abwärme für Elektronikgehäuse, insbesondere für den Automobilbereich. Das Kühlsystem ist an die Geometrie des Gehäuses angepasst.

In der US 2001/036061 A1 wird eine Vorrichtung zum Ableiten von Wärme von einem Festplattenlaufwerk bereitgestellt, einschließlich einer U-förmigen Wärmeaustauschklemme, die elastisch an gegenüberliegenden Oberflächen eines Festplattenlaufwerks angebracht ist.

Gemäß der WO 2015/037824 A1 werden ein Wärmetauscher zum Kühlen eines elektrischen Bauteils und eine Wärmetauscheranordnung zum Kühlen eines elektrischen Bauteiles bereitgestellt die in der Lage sind, ein Einführen des elektrischen Bauteils zu erleichtern und die Kühlleistung durch das in-Kontakt-Bringen von beiden Seitenoberflächen des elektrischen Bauteils mit einem Rohr, in dem Kühlwasser strömt, zu verbessern.

Die WO 2004/085209 A1 offenbart eine elektronische Fahrzeugsteuereinheit, umfassend eine Leiterplatte, an der mindestens eine elektronische Komponente angebracht ist, ein Kühlelement in thermischem Kontakt mit der Leiterplatte und eine Platte mit einem Rohr, das damit verbunden ist, um ein Kühlfluid darin strömen zu lassen. Die Leiterplatte und das Kühlelement sind von einer Abdeckung bedeckt, die aus einem Kunststoffmaterial hergestellt ist.

Es ist Aufgabe der Erfindung, eine verbesserte Vorrichtung mit einem Rohrkühler und einem Elektronikgehäuse bereitzustellen.

Diese Aufgabe wird mittels einer Vorrichtung gemäß dem unabhängigen Patentanspruch gelöst. Vorteilhafte Ausführungsformen und Weiterbildungen ergeben sich aus den abhängigen Ansprüchen, der nachfolgenden Beschreibung und den Zeichnungen.

Es wird eine Vorrichtung mit einem Elektronikgehäuse und einem Rohrkühler angegeben. Gemäß einem vorliegend nicht beanspruchten Aspekt wird ein Rohrkühler für ein Elektronikgehäuse angegeben.

Es wurde erkannt, dass ein verbesserter Rohrkühler für ein Elektronikgehäuse dadurch bereitgestellt werden kann, dass der Rohrkühler ein einteilig und materialeinheitlich ausgebildetes Rohr aufweist. Das Rohr ist mit einem Kühlmittel füllbar. Das Rohr umfasst eine Rohrschlange, einen ersten Rohrabschnitt und einen ersten Verbindungsabschnitt. Der erste Rohrabschnitt ist mit einer Kühlmittelversorgung zur Zuführung des Kühlmittels verbindbar. Der erste Verbindungsabschnitt verbindet den ersten Rohrabschnitt mit einer ersten Seite der Rohrschlange fluidisch.

Der erste Rohrabschnitt ist lateral versetzt zu der Rohrschlange angeordnet. Das bedeutet insbesondere, dass der erste Rohrabschnitt in Draufsicht entlang des Abstandsvektors zwischen erstem Rohrabschnitt und Rohrschlange in einer Richtung
senkrecht zu einer Haupterstreckungsrichtung des ersten Rohrabschnitts zu der Rohrschlange versetzt ist.

Zwischen dem ersten Rohrabschnitt und der Rohrschlange ist das Elektronikgehäuse anordenbar, wobei sich die Rohrschlange und der erste Rohrabschnitt auf einer gemeinsamen Seite des ersten Verbindungabschnitts erstrecken. Dass sich die Rohrschlange und der erste Rohrabschnitt auf einer gemeinsamen Seite des ersten Verbindungabschnitts erstrecken, bedeutet insbesondere, dass sich der erste Rohrabschnitt und die Rohrschlange ausgehend von ihrem Anschlussbereich an den ersten Verbindungsabschnitt in denselben Halbraum erstrecken. Der Halbraum wird insbesondere von einer Ebene definiert, die parallel zum Abstandsvektor zwischen erstem Rohrabschnitt und Rohrschlange und senkrecht oder geneigt zur Haupterstreckungsrichtung des ersten Rohrabschnitts verläuft.

Das Elektronikgehäuse hat eine Oberseite und eine zur Oberseite versetzt angeordnete Unterseite. Anders ausgedrückt liegen die Oberseite und die Unterseite einander gegenüber, insbesondere derart, dass ein Innenraum des Elektronikgehäuses an gegenüberliegenden Seiten von der Oberseite und der Unterseite begrenzt wird. Mit anderen Worten begrenzen die Oberseite und die Unterseite das Elektronikgehäuse in einander entgegen gesetzten Raumrichtungen. Die Rohrschlange ist der Unterseite des Elektronikgehäuses zugeordnet und der erste Rohrabschnitt ist der Oberseite des Elektronikgehäuses zugeordnet. Anders ausgedrückt verläuft die Rohrschlange entlang der Unterseite des Elektronikgehäuses und der erste Rohrabschnitt verläuft entlang der Oberseite des Elektronikgehäuses. Der erste Verbindungsabschnitt ist seitlich am Elektronikgehäuse vorbeigeführt.

Der Verbindungsabschnitt ist - insbesondere abschnittsweise oder über seine gesamte Länge- geneigt gegenüber der Rohrschlange und dem ersten Rohrabschnitt angeordnet. Er kann auch - abschnittsweise oder über seine gesamte Länge - gekrümmt von der Rohrschlange zum ersten Rohrabschnitt verlaufen.

Auf diese Weise kann eine beidseitige Entwärmung des Elektronikgehäuses durch den Rohrkühler gewährleistet werden. Ferner können Leckagen des Rohrs vermieden werden. Der Rohrkühler ist besonders einfach am Elektronikgehäuse montierbar, insbesondere mittels Aufschieben des Rohrkühlers auf das Elektronikgehäuse entlang einer zu den Haupterstreckungsebenen von Oberseite und Unterseite parallelen Richtung.

In einer weiteren Ausführungsform weist das Rohr einen zweiten Rohrabschnitt und einen zweiten Verbindungsabschnitt auf. Der zweite Verbindungsabschnitt verbindet den zweiten Rohrabschnitt fluidisch mit einer zweiten Seite der Rohrschlange.

Der zweite Rohrabschnitt ist lateral versetzt zu der Rohrschlange angeordnet, wobei sich die Rohrschlange und der zweite Rohrabschnitt auf einer gemeinsamen Seite des zweiten Verbindungabschnitts erstrecken. Dass der zweite Rohrabschnitt lateral versetzt zu der Rohrschlange angeordnet ist bedeutet insbesondere, dass der zweite Rohrabschnitt in Draufsicht entlang des Abstandsvektors zwischen zweitem Rohrabschnitt und Rohrschlange in einer Richtung senkrecht zu einer Haupterstreckungsrichtung des zweiten Rohrabschnitts zu der Rohrschlange versetzt ist. Dass sich die Rohrschlange und der zweite Rohrabschnitt auf einer gemeinsamen Seite des zweiten Verbindungabschnitts erstrecken, bedeutet insbesondere, dass sich der zweite Rohrabschnitt und die Rohrschlange ausgehend von ihrem Anschlussbereich an den zweiten Verbindungsabschnitt in denselben Halbraum erstrecken. Der Halbraum wird insbesondere von einer Ebene definiert, die parallel zum Abstandsvektor zwischen zweitem Rohrabschnitt und Rohrschlange und senkrecht oder geneigt zur Haupterstreckungsrichtung des zweiten Rohrabschnitts verläuft. Es handelt sich vorzugsweise um denselben Halbraum, in den sich der erste Rohrabschnitt und die Rohrschlange erstrecken.

Der zweite Verbindungsabschnitt ist - insbesondere abschnittsweise oder über seine gesamte Länge- geneigt zu der Rohrschlange und dem zweiten Rohrabschnitt angeordnet. Er kann auch - abschnittsweise oder über seine gesamte Länge - gekrümmt von der Rohrschlange zum zweiten Rohrabschnitt verlaufen.

In einer weiteren Ausführungsform sind die Rohrschlange in einer ersten Haupterstreckungsebene und der erste Rohrabschnitt in einer zweiten Haupterstreckungsebene angeordnet. Zwischen erster und zweiter Haupterstreckungsebene ist insbesondere das Elektronikgehäuse anordenbar. Die erste Haupterstreckungsebene ist parallel zur zweiten Haupterstreckungsebene angeordnet.

In einer weiteren Ausführungsform ist der zweite Rohrabschnitt in der zweiten Haupterstreckungsebene angeordnet. Vorzugsweise ist der zweite Rohrabschnitt parallel zum ersten Rohrabschnitt angeordnet. Dadurch kann der Rohrkühler besonders einfach aus dem einteilig und materialeinheitlich ausgebildeten Rohr gebogen werden.

In einer weiteren Ausführungsform sind der erste Verbindungsabschnitt und der zweite Verbindungsabschnitt in einer gemeinsamen dritten Haupterstreckungsebene angeordnet. Vorzugsweise ist der zweite Verbindungsabschnitt geneigt zu dem ersten Verbindungsabschnitt angeordnet, und zwar insbesondere in der dritten Haupterstreckungsebene. Durch die gemeinsame Anordnung in der dritten Haupterstreckungsebene ist der Rohrkühler auf einer - der dritten Haupterstreckungsebene gegenüberliegenden - Seite hin offen ausgebildet. Dadurch kann der Rohrkühler besonders einfach auf das Elektronikgehäuse aufgeschoben werden. Ferner wird die beidseitige Kühlung des Elektronikgehäuses sichergestellt.

In einer weiteren Ausführungsform ist der erste Verbindungsabschnitt senkrecht zumindest abschnittsweise zu dem ersten Rohrabschnitt und/oder zumindest abschnittsweise zu der Rohrschlange angeordnet. Dadurch kann eine besonders kompakte Ausgestaltung des Rohrkühlers sichergestellt werden.

In einer weiteren Ausführungsform weist die Rohrschlange einen ersten Rohrschlangenabschnitt, einen zweiten Rohrschlangenabschnitt und wenigstens einen dritten Rohrschlangenabschnitt auf. Der zweite Rohrschlangenabschnitt verbindet fluidisch den ersten Rohrschlangenabschnitt mit dem dritten Rohrschlangenabschnitt, insbesondere an einer von dem ersten Verbindungsabschnitt abgewandten Seite des ersten Rohrschlangenabschnitts. Der erste Rohrschlangenabschnitt ist zumindest abschnittsweise parallel zum dritten Rohrschlangenabschnitt angeordnet. Vorzugsweise ist der zweite Rohrschlangenabschnitt zumindest abschnittsweise rechtwinklig zum ersten und/oder dritten Rohrschlangenabschnitt angeordnet. Dadurch kann eine besonders kompakte, insbesondere in Draufsicht auf die erste Haupterstreckungsebene U-förmige, Rohrschlange ausgebildet werden, die eine hohe Wärmeabfuhr sicherstellt.

In einer weiteren Ausführungsform ist der erste Rohrabschnitt und/oder der zweite Rohrabschnitt parallel zum ersten Rohrschlangenabschnitt und/oder dem dritten Rohrschlangenabschnitt angeordnet. Dadurch kann der Rohrkühler besonders einfach gebogen werden.

In einer weiteren Ausführungsform weist der erste Rohrschlangenabschnitt und der dritte Rohrschlangenabschnitt einen ersten Abstand zueinander auf. Der erste Rohrabschnitt und der zweite Rohrabschnitt weisen einen zweiten Abstand zueinander auf. Der zweite Abstand ist unterschiedlich zum ersten Abstand. Vorzugsweise ist der zweite Abstand größer als der erste Abstand.

In einer weiteren Ausführungsform umfasst das Rohr einen Anschlussabschnitt, wobei der Anschlussabschnitt mit dem ersten Rohrabschnitt fluidisch verbunden ist. Der Anschlussabschnitt ist in Richtung zu der der Rohrschlange abgewandten Seite versetzt zu dem ersten Rohrabschnitt angeordnet. Dadurch kann der Rohrkühler über den Anschlussabschnitt besonders einfach mit der Kühlmittelzuführung verbunden werden.

In einer weiteren Ausführungsform ist der Anschlussabschnitt des Rohrkühlers beabstandet zu der Oberseite des Elektronikgehäuses angeordnet. Dadurch wird eine besonders einfach zugängliche Anschlussmöglichkeit für die Verbindung des Rohrkühlers mit der Kühlmittelversorgung sichergestellt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
Figur 1 eine perspektivische Ansicht eines Elektronikgehäuses;
Figur 2 eine perspektivische Ansicht eines Rohrkühlers gemäß einem Ausführungsbeispiel;
Figur 3 eine Explosionsdarstellung einer Vorrichtung gemäß einem Ausführungsbeispiel;
Figur 4 eine perspektivische Ansicht der Vorrichtung;
Figur 5 eine weitere perspektivische Ansicht der Vorrichtung; und
Figur 6 eine Schnittansicht entlang einer in Figur 5 gezeigten Schnittebene A-A durch die Vorrichtung
zeigen.

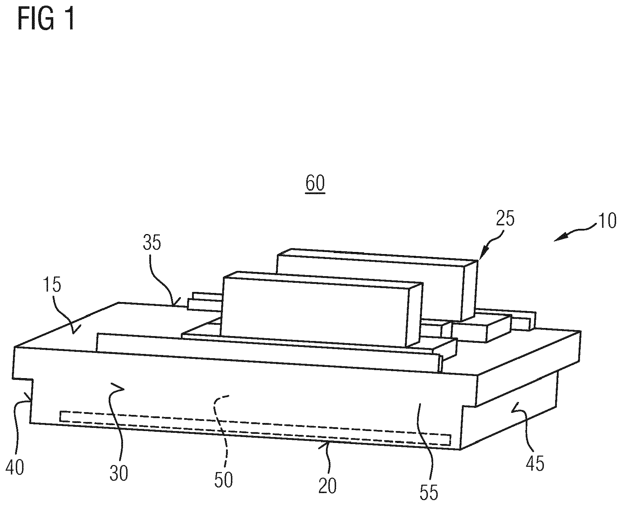

Figur 1 zeigt eine perspektivische Ansicht eines Elektronikgehäuses 10. Das Elektronikgehäuse 10 hat in Draufsicht im Wesentlichen eine rechteckförmige Grundform. Das Elektronikgehäuse 10 weist eine Oberseite 15 und eine der Oberseite 15 gegenüberliegend angeordnete Unterseite 20 auf. Die Oberseite 15 und die Unterseite 20 sind bevorzugterweise abschnittsweise plan ausgebildet. Aus der Oberseite 15 ragen bevorzugterweise mehrere Elektronikgehäuseanschlüsse 25 - insbesondere Steckverbinder - des Elektronikgehäuses 10 heraus. Des Weiteren hat das Elektronikgehäuse 10 eine in Fig. 1 dem Betrachter zugewandte erste Seitenfläche 30 und eine in Fig. 1 vom Betrachter abgewandte zweite Seitenfläche 35. Des Weiteren weist das Elektronikgehäuse 10 eine in Figur 1 seitlich links und rechts beispielhaft angeordnete dritte eine vierte Seitenfläche 40, 45 auf.

Die erste Seitenfläche 30 und die zweite Seitenfläche 35 sind bevorzugterweise plan ausgebildet und verlaufen bevorzugterweise parallel zueinander. Die dritte Seitenfläche und die vierte Seitenfläche 40, 45 können gestuft ausgebildet sein. Dabei sind die dritte und vierte Seitenfläche 40, 45 bevorzugterweise rechtwinklig zur ersten und zweiten Seitenfläche 30, 35 angeordnet. Dabei verlaufen bevorzugterweise die dritte und vierte Seitenfläche 40, 45 parallel zueinander. Die Seitenflächen 30, 35, 40, 45 sind ferner rechtwinklig zu der Oberseite 15 und der Unterseite 20 angeordnet. Auch können die Seitenflächen 30, 35, 40, 45 sowie die Oberseite 15 und die Unterseite 20 anders zueinander ausgerichtet sein. Auch kann darauf verzichtet werden, dass der Elektronikgehäuseanschluss 25 aus der Oberseite 15 herausragt. Der Elektronikgehäuseanschluss 25 kann auch an einer anderen Position des Elektronikgehäuses 10 angeordnet sein.

Das Elektronikgehäuse 10 umschließt einen Elektronikgehäuseinnenraum 50, in dem eine Elektronikbaugruppe 55 (in Figur 1 strichliert schematisch dargestellt) zur Steuerung einer Komponente eines Kraftfahrzeugs angeordnet ist. Die Elektronikbaugruppe 55 ist mit Elektronikgehäuseanschlüssen 25 elektrisch verbunden. Das Elektronikgehäuse 10 ist vorzugsweise fluiddicht gegenüber einer Umgebung 60 des Elektronikgehäuses 10 ausgebildet. Im Betrieb der Elektronikbaugruppe 55 erzeugt diese Wärme.

Die Elektronikbaugruppe 55 kann über den Elektronikgehäuseanschluss 25 elektrisch mit weiteren elektrischen und/oder elektronischen Komponenten eines Kraftfahrzeugs elektrisch verbunden werden.

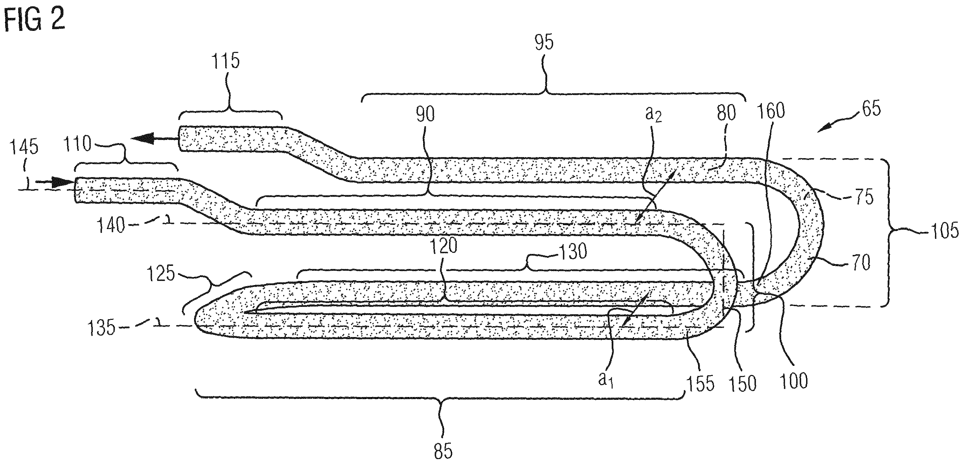

Figur 2 zeigt eine perspektivische Ansicht eines Rohrkühlers 65 für das in Figur 1 gezeigte Elektronikgehäuse 10. Der Rohrkühler 65 weist ein einteilig und materialeinheitlich ausgebildetes Rohr 70 auf. Das Rohr 70 hat bevorzugterweise einen kreisförmigen Querschnitt. Das Rohr 70 begrenzt einen Rohrinnenraum 75, in dem ein Kühlmittel 80 angeordnet ist. Das Kühlmittel 80 kann flüssig und/oder gasförmig sein. Insbesondere kann hierbei das Rohr 70 auch als Wärmerohr ausgebildet sein.

Das Rohr 70 weist bevorzugterweise eine Rohrschlange 85, einen ersten Rohrabschnitt 90, einen zweiten Rohrabschnitt 95, einen ersten Verbindungsabschnitt 100, einen zweiten Verbindungsabschnitt 105, einen ersten Anschlussabschnitt 110 und einen zweiten Anschlussabschnitt 115 auf.

Die Rohrschlange 85 weist bevorzugterweise einen ersten Rohrschlangenabschnitt 120, einen zweiten Rohrschlangenabschnitt 125 und einen dritten Rohrschlangenabschnitt 130 auf. Die Rohrschlange 85 ist in einer ersten Haupterstreckungsebene 135 angeordnet. Der erste Rohrschlangenabschnitt 120 ist bevorzugterweise geradlinig ausgebildet. Der zweite Rohrschlangenabschnitt 125 ist in der Ausführungsform bevorzugterweise rechtwinklig zum ersten Rohrschlangenabschnitt 120 angeordnet und mit dem ersten Rohrschlangenabschnitt 120 fluidisch verbinden. Der dritte Rohrschlangenabschnitt 130 ist bevorzugterweise parallel zum ersten Rohrschlangenabschnitt 120 ebenso in der dritten Haupterstreckungsebene 150 angeordnet. Der dritte Rohrschlangenabschnitt 130 ist fluidisch mit dem zweiten Rohrschlangenabschnitt 125 verbunden, sodass der zweite Rohrschlangenabschnitt 125 den ersten Rohrschlangenabschnitt 120 mit dem dritten Rohrschlangenabschnitt 130 fluidisch verbindet. In der Ausführungsform ist beispielhaft der zweite Rohrschlangenabschnitt 125 geradlinig ausgebildet. Auch kann der zweite Rohrschlangenabschnitt 125 mäanderförmig ausgestaltet sein. Der dritte Rohrschlangenabschnitt 130 ist vorzugsweise ebenso geradlinig ausgebildet. Weitere Ausgestaltungen des ersten, zweiten und des dritten Rohrschlangenabschnitts 120, 125, 130 sind auch denkbar. Auch kann der zweite Rohrschlangenabschnitt 125 schräg zum ersten und/oder dritten Rohrschlangenabschnitt 120, 130 angeordnet sein. Durch die rechtwinklige Anordnung des zweiten Rohrschlangenabschnitts 125 und die parallele Anordnung des ersten und dritten Rohrschlangenabschnitts 120, 130 zueinander weist die Rohrschlange 85 eine im Wesentliche U-förmige Grundform in einer Draufsicht auf die erste Haupterstreckungsebene 135 auf.

Der erste Rohrabschnitt 90 und der zweite Rohrabschnitt 95 sind bevorzugterweise parallel und versetzt zueinander in einer zweiten Haupterstreckungsebene 140 angeordnet. Die zweite Haupterstreckungsebene 140 ist dabei vorzugsweise parallel zu der ersten Haupterstreckungsebene 135 angeordnet. Auch kann die zweite Haupterstreckungsebene 140 geneigt zur ersten Haupterstreckungsebene 135 angeordnet sein. Das Elektronikgehäuse 10 ist insbesondere zwischen erster und zweiter Haupterstreckungsebene 135, 140 anordenbar, wobei beispielsweise die Gehäuseanschlüsse 25 oder dergleichen über die erste bzw. zweite Haupterstreckungsebene 135, 140 hinausragen können.

Der erste Rohrabschnitt 90 und die Rohrschlange 85 erstrecken sich auf einer gemeinsamen Seite des ersten Verbindungabschnitts 100. Der zweite Rohrabschnitt 95 und die Rohrschlange 85 erstrecken sich auf einer gemeinsamen Seite des zweiten Verbindungabschnitts 105. Somit ist die Rohrschlange 85 und die Rohrabschnitte 90, 95 auf der gleichen Seite zu den Verbindungabschnitten 100, 105 angeordnet.

Der erste Anschlussabschnitt 110 ist vorzugsweise parallel zum ersten Rohrabschnitt 90 und der zweite Anschlussabschnitt 115 ist parallel vorzugsweise zum zweiten Rohrabschnitt 95 angeordnet. Dabei ist der Anschlussabschnitt 110, 115 in Richtung zu der der Rohrschlange 85 abgewandten Seite versetzt zu dem Rohrabschnitt 90, 95 angeordnet. Ferner sind der erste Anschlussabschnitt 110 und der zweite Anschlussabschnitt 95 parallel zueinander angeordnet. Der erste Anschlussabschnitt 90 und der zweite Anschlussabschnitt 115 sind ferner in einer Anschlussebene 145 angeordnet. Die Anschlussebene 145 ist bevorzugterweise parallel zur ersten und/oder zweiten Haupterstreckungsebene 135, 140 bevorzugterweise zu einer von der Rohrschlange 85 abgewandten Seite hin versetzt angeordnet. Der erste Anschlussabschnitt 110 ist mit einer Kühlmittelversorgung zur Zuführung des Kühlmittels 80 verbindbar. Der zweite Anschlussabschnitt 115 kann mit der Kühlmittelversorgung zur Abführung des Kühlmittels 80 verbunden sein.

Der erste Verbindungsabschnitt 100 und der zweite Verbindungsabschnitt 105 sind bevorzugterweise zumindest stellenweise in einer gemeinsamen dritten Haupterstreckungsebene 150 angeordnet. Vorliegend verlaufen Sie gekrümmt vom ersten bzw. zweiten Rohrabschnitt 90 bzw. 95 zu der Rohrschlange 85 hin, wobei ein Mittelbereich des ersten bzw. zweiten Verbindungsabschnitts 100, 105 in der dritten Haupterstreckungsebene 150 angeordnet ist, welche den Halbraum begrenzt in den sich Rohrschlange 85 und erster bzw. zweiter Rohrabschnitt 90, 95 ausgehend vom jeweiligen Verbindungsabschnitt 100, 105 hinein erstrecken.

Der erste Rohrschlangenabschnitt 120 und der dritte Rohrschlangenabschnitt 130 weisen einen ersten Abstand a₁ auf. Der erste Rohrabschnitt 90 und der zweite Rohrabschnitt 95 weisen einen zweiten Abstand a₂ auf. Der zweite Abstand a₂ ist verschieden vom ersten Abstand a₁ und vorzugsweise größer als der erste Abstand a₁. Dadurch ergibt sich, dass der erste Verbindungsabschnitt 100 - in Projektion auf die dritte Haupterstreckungsebene 150 - geneigt zu dem zweiten Verbindungsabschnitt 105 verläuft. Auch kann der erste Abstand a₁ und der zweite Abstand a₂ identisch sein. In dieser Ausgestaltung wäre dann der erste Verbindungsabschnitt 100 parallel zum zweiten Verbindungsabschnitt 105 angeordnet.

Der erste Verbindungsabschnitt 100 kann auch geneigt zu dem ersten Rohrabschnitt 90 und zu der Rohrschlange 85 angeordnet sein. Der zweite Verbindungsabschnitt 105 kann auch geneigt zu dem zweiten Rohrabschnitt 95 und der Rohrschlange 85 angeordnet sein. Vorzugsweise ist der Verbindungsabschnitt 100, 105 zumindest abschnittsweise senkrecht zu dem Rohrabschnitt 90, 95 und/oder zu der Rohrschlange 85.

Der ersten Anschlussabschnitt 110 ist fluidisch mit dem ersten Rohrabschnitt 90 verbunden. Der erste Rohrabschnitt 90 ist fluidisch mit dem ersten Verbindungsabschnitt 100 verbunden. Ferner ist der erste Verbindungsabschnitt 100 mit einer Eingangsseite 155 der Rohrschlange 85 verbunden. Die Eingangsseite 155 der Rohrschlange 85 ist beispielhaft am ersten Rohrschlangenabschnitt 120 auf einer vom zweiten Rohrschlangenabschnitt 125 abgewandten Seite angeordnet. Die Rohrschlange 85 weist auf einer vom zweiten Rohrschlangenabschnitt 125 abgewandten Seite des dritten Rohrschlangenabschnitts 130 eine Ausgangsseite 160 auf. An der Ausgangsseite 160 ist die Rohrschlange 85 fluidisch mit dem zweiten Verbindungsabschnitt 105 verbunden. Dabei verbindet der zweite Verbindungsabschnitt 105 die Rohrschlange 85 ausgangsseitig mit dem zweiten Rohrabschnitt 95 fluidisch. Der zweite Rohrabschnitt 95 ist auf einer vom zweiten Verbindungsabschnitt 105 abgewandten Seite mit dem zweiten Anschlussabschnitt 115 fluidisch verbunden.

Das Kühlmittel 80 wird über den ersten Anschlussabschnitt 110 in den Rohrkühler 65 eingeleitet. Das Kühlmittel 80 strömt über den ersten Anschlussabschnitt 110 in den ersten Rohrabschnitt 90. Vom ersten Rohrabschnitt 90 strömt das Kühlmittel 80 in den ersten Verbindungsabschnitt 100. Nach Durchströmen des ersten Verbindungsabschnitts 100 tritt das Kühlmittel 80 über die Eingangsseite 155 in die Rohrschlange 85 ein und durchströmt dabei zuerst den ersten Rohrschlangenabschnitt 120, dann den zweiten Rohrschlangenabschnitt 125 und im Anschluss daran den dritten Rohrschlangenabschnitt 130. An der Ausgangsseite 160 tritt das Kühlmittel 80 aus der Rohrschlange 85 in den zweiten Verbindungsabschnitt 105 ein. Nach Durchströmen des zweiten Verbindungsabschnitts 105 tritt das Kühlmittel 80 in den zweiten Rohrabschnitt 95 ein. Nach Durchströmen des zweiten Rohrabschnitts 95 strömt das Kühlmittel 80 durch den zweiten Anschlussabschnitt 115 und wird über den zweiten Anschlussabschnitt 115 zur Kühlmittelversorgung zurückgeführt.

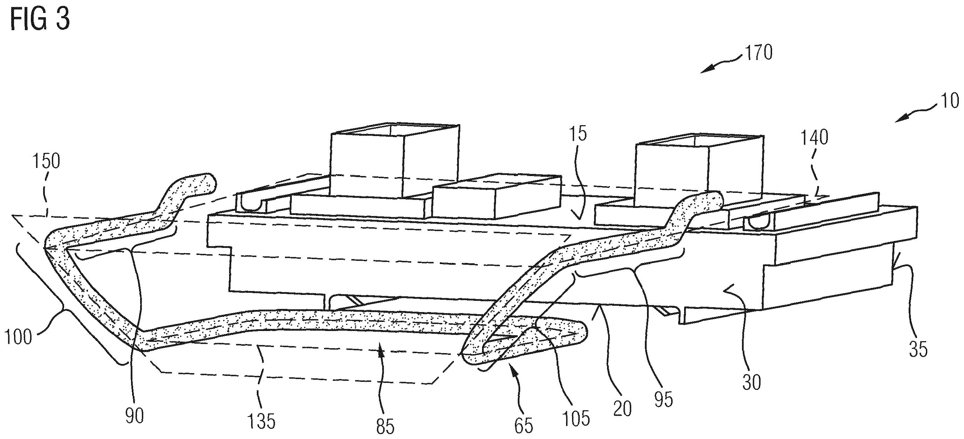

Figur 3 zeigt eine Explosionsdarstellung einer Vorrichtung 170 bestehend aus dem in Figur 1 erläuterten Elektronikgehäuse 10 und dem in Figur 2 erläuterten Rohrkühler 65. Die Explosionsdarstellung entspricht im Wesentlichen einer Anordnung des Rohrkühlers 65 vor einem Aufschieben auf das Elektronikgehäuse 10. Durch die versetzte Anordnung der Rohrabschnitte 90, 95 in der zweiten Haupterstreckungsebene 140 zu der Anordnung der Rohrschlange 85 in der ersten Haupterstreckungsebene 135 sowie die Anordnung der Verbindungsabschnitte 100, 105 der gemeinsamen dritten Haupterstreckungsebene 150 ist der Rohrkühler 65 auf der zum Elektronikgehäuse 10 zugewandten Seite hin offen.

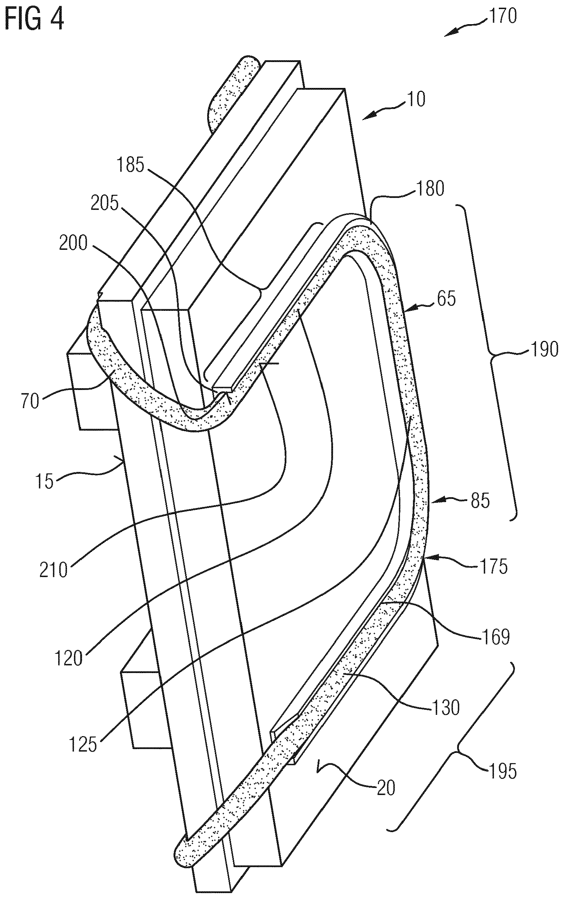

Figur 4 zeigt eine perspektivische Ansicht der in Figur 3 gezeigten Vorrichtung 170. Der Rohrkühler 65 ist auf das Elektronikgehäuse 10 aufgeschoben. Dabei verläuft die Rohrschlange 85 entlang der Unterseite 20 des Elektronikgehäuses 10. Die Rohrschlange 85 weist dabei einen ersten Berührkontakt 169 mit der Unterseite 20 auf.

Zusätzlich weist das Elektronikgehäuse 10 bevorzugterweise ein erstes Befestigungsmittel 175 auf. Das erste Befestigungsmittel 175 ist an der Unterseite 20 angeordnet. Auf das erste Befestigungsmittel 175 kann auch verzichtet werden. Das erste Befestigungsmittel 175 weist einen ersten Steg 180 auf. Der erste Steg 180 ist an der Unterseite 20 befestigt. Der erste Steg 180 weist einen ersten Stegabschnitt 185, einen zweiten Stegabschnitt 190 und einen dritten Stegabschnitt 195 auf. Der erste Stegabschnitt 185 ist korrespondierend zum ersten Rohrschlangenabschnitt 120, der zweite Stegabschnitt 190 ist korrespondierend zum zweiten Rohrschlangenabschnitt 125 und der dritte Stegabschnitt 195 ist korrespondierend zum dritten Rohrschlangenabschnitt 130 angeordnet. Somit verläuft auch der erste Stegabschnitt 185 parallel zum dritten Stegabschnitt 195 und der zweite Stegabschnitt 190 ist senkrecht zum ersten Stegabschnitt 185 und zum dritten Stegabschnitt 195 angeordnet.

In den Stegabschnitten 185, 190, 195 ist eine Ausnehmung 200 ausgebildet, die bevorzugterweise entlang des ersten Steges 180 durchlaufend ausgebildet ist. Die erste Ausnehmung 200 weist eine erste Ausnehmungsfläche 205 auf. Die erste Ausnehmungsfläche 205 ist korrespondierend zu einer äußeren Umfangsfläche 210 der Rohrschlange 85 ausgebildet.

Die Rohrschlange 85 greift in die erste Ausnehmung 200 abschnittsweise ein. Mittels der - durch die Stegabschnitte 185, 190, 195 durchlaufenden - ersten Ausnehmung 200 wird ein Einrasten der Rohrschlange 85 in der ersten Ausnehmung 200 sicher gewährleistet. Insbesondere wird durch den ersten Stegabschnitt 185 und den dritten Stegabschnitt 195 ein seitliches Verschieben des Rohrkühlers 65 auf dem Elektronikgehäuse 10 vermieden. Durch den zweiten Stegabschnitt 190 wird ein Abziehen des Rohrkühlers 65 vom Elektronikgehäuse 10 vermieden. Von besonderem Vorteil ist hierbei, wenn die erste Ausnehmung 200 im Wesentlichen halbkreisförmig ausgebildet ist. Ferner wird durch die korrespondierende Ausgestaltung der ersten Ausnehmungsfläche 205 und der äußeren Umfangsfläche 210 des Rohrs 70 eine gute Wärmeübertragung zwischen dem Elektronikgehäuse 10 und dem Rohrkühler 65 gewährleistet. Dadurch kann die Elektronik 55 besonders gut im Elektronikgehäuse 10 gekühlt werden.

Ferner ist auch denkbar, dass das erste Befestigungsmittel weitere Elemente aufweist um den Rohrkühler 65 an dem Elektronikgehäuse 10 zu fixieren. Ferner kann auf das erste Befestigungsmittel 175 verzichtet werden. Auch kann das in Figur 4 gezeigte erste Befestigungsmittel 175 andersartig ausgebildet sein.

Auch kann auf den ersten Steg 220, 225 verzichtet werden, so dass die Rohrschlange 85 direkt an der Unterseite 20 des Elektronikgehäuses 10 anliegt. Auch kann die erste Ausnehmung 200 direkt im Elektronikgehäuse 10 außenseitig an der Unterseite 20 angeordnet sein.

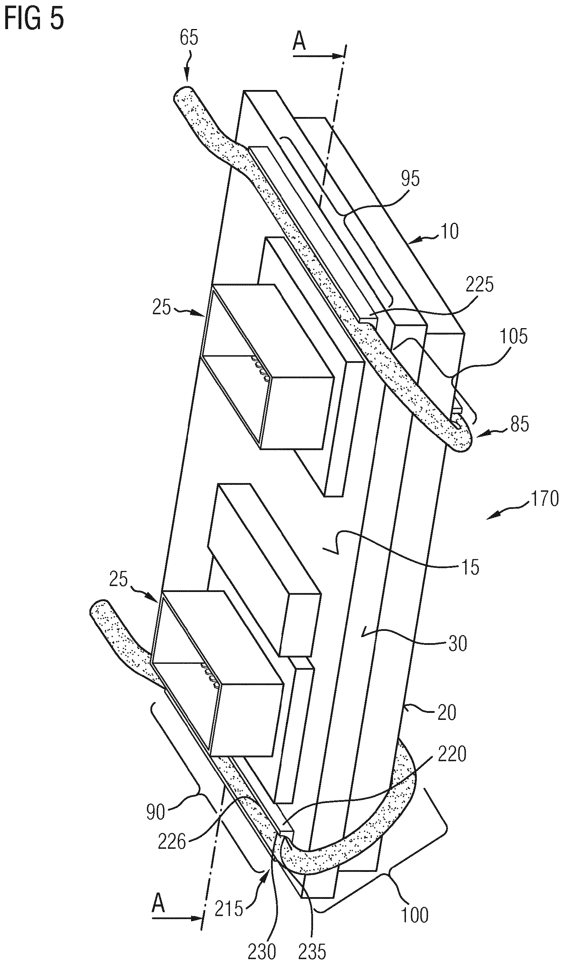

Figur 5 zeigt eine perspektivische Ansicht der in Figur 4 gezeigten Vorrichtung 170, bei welcher der Rohrkühler 65 auf das Elektronikgehäuse 10 aufgeschoben ist. Durch die einseitig offene Ausgestaltung des Rohrkühlers 65 sind der erste Verbindungsabschnitt 100 und der zweite Verbindungsabschnitt 105 an der ersten Seitenfläche 30 vorbeigeführt, sodass die Verbindungsabschnitte 100, 105 die an der Oberseite 15 angeordneten Rohrabschnitte 90, 95 fluidisch mit der an der Unterseite 20 angeordneten Rohrschlange 85 verbinden können.

In der vorliegenden Ausführungsform ist beispielhaft zwischen dem ersten Rohrabschnitt 90 und dem zweiten Rohrabschnitt 95 der Elektronikgehäuseanschluss 25 angeordnet. Selbstverständlich können der erste und/oder der zweite Rohrabschnitt 90, 95 bei Vorsehen von zwei Elektronikgehäuseanschlüssen 25 (wie in Figur 5 gezeigt) zwischen den beiden Elektronikgehäuseanschlüssen 25 geführt werden.

Ferner ist an dem Elektronikgehäuse 10 bevorzugterweise ein zweites Befestigungsmittel 215 vorgesehen. Das zweite Befestigungsmittel 215 weist einen zweiten Steg 220 und einen dritten Steg 225 auf. Der zweite Steg 220 und der dritte Steg 225 sind an der Oberseite 15 des Elektronikgehäuses 10 befestigt. Der zweite Steg 220 ist dabei bevorzugterweise parallel zum dritten Steg 225 angeordnet. Dabei ist die Anordnung des zweiten Stegs 220 bevorzugterweise korrespondierend zum ersten Rohrabschnitt 90 und der dritte Steg 225 korrespondierend zum zweiten Rohrabschnitt 95 angeordnet.

Der zweite Steg 220 weist eine zweite Ausnehmung 230 mit einer zweiten Ausnehmungsfläche 235 auf. Die zweite Ausnehmung 230 ist bevorzugterweise im Wesentlichen halbkreisförmig korrespondierend zur äußeren Umfangsfläche 210 des ersten Rohrabschnitts 90 ausgebildet. Dadurch wird ein flächiger zweiter Berührkontakt 226 zwischen dem ersten Rohrabschnitt 90 und dem zweiten Steg 220 sichergestellt. Dadurch wird eine gute oberseitige Wärmeabführung aus dem Elektronikgehäuse 10 und somit eine gute oberseitige Kühlung der Elektronik 55 gewährleistet.

Der dritte Steg 225 ist ähnlich zum zweiten Steg 220 ausgebildet. Auch der dritte Steg 225 weist eine dritte Ausnehmung 240 mit einer dritten Ausnehmungsfläche 245 auf. Die dritte Ausnehmungsfläche 245 ist korrespondierend zur äußeren Umfangsfläche 210 des Rohrs 70 ausgebildet. Dadurch wird ein flächiger dritter Berührkontakt 227 zwischen dem zweiten Rohrabschnitt 95 und dem dritten Steg 225 sichergestellt. Auch ist die dritte Ausnehmung 240 bevorzugterweise im Wesentlichen halbkreisförmig ausgebildet.

Durch die zweite und dritte Ausnehmung 230, 240 wird oberseitig ein seitliches Verschieben der Rohrabschnitte 90, 95 und somit des Rohrkühlers 65 vermieden. Auf diese Weise wird ein sicherer Sitz des Rohrkühlers 65 und ein einfaches Aufschieben des Rohrkühlers 65 auf das Elektronikgehäuse 10 sicher gewährleistet. Dadurch können die Montagekosten für die Vorrichtung 170 niedrig gehalten werden. Insbesondere kann bevorzugterweise auf weitere Befestigungsmittel verzichtet werden.

Auch kann der Rohrabschnitt 90, 95 direkt an der Oberseite 15 des Elektronikgehäuses 10 anliegen. Auch kann die zweite und/oder dritte Ausnehmung 230, 240 direkt im Elektronikgehäuse 10 außenseitig an der Oberseite 15 angeordnet sein.

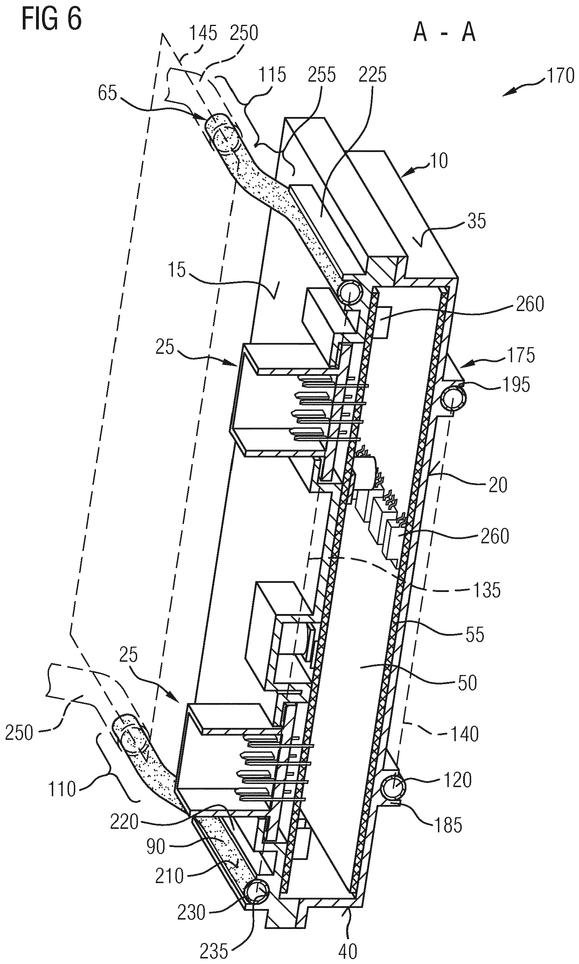

Figur 6 zeigt eine Schnittansicht entlang einer in Figur 5 gezeigten Schnittebene A-A.

Durch den Versatz der Anschlussebene 145 zu der ersten und zweiten Haupterstreckungsebene 135, 140 kann ein erleichtertes Aufschieben einer Schlauchleitung 250 auf den Anschlussabschnitt 110, 115 gewährleistet werden. Auch kann die Anschlussebene 145 in der ersten Haupterstreckungsebene 135 angeordnet sein.

In den Figuren 1 bis 6 weist das Rohr 70 zwischen den Rohrabschnitten 90, 95, Rohrschlangenabschnitten 120, 125, 130, Verbindungsabschnitten 100, 105 und/oder Anschlussabschnitten 110, 115 bogenförmige Bereiche 255 auf. Diese dienen dazu, um ein Knicken des Rohrs 70 beim Biegen aus einem durchgängigen, ggf. geradlinigen Rohrmaterial zu vermeiden. Auf die Bogenbereiche 255 auch verzichtet werden. Auch können die Bogenbereiche 255 eine andere geometrische Ausgestaltung, insbesondere einen anderen Radius, aufweisen.

Durch die in den Figuren 1 bis 6 gezeigte Vorrichtung 170 mit dem Rohrkühler 65 und dem Elektronikgehäuse 10 kann eine besonders einfach ausgebildete und zu montierende Vorrichtung 170 bereitgestellt werden. Insbesondere kann hierbei auf besonders teure Lötschritte in der Herstellung des Rohrkühlers 65 verzichtet werden. Des Weiteren ist der Rohrkühler 65 besonders einfach auf das Elektronikgehäuse 10 aufsteckbar und kann ebenso besonders leicht wieder demontiert werden. Ferner werden durch die einteilige und materialeinheitliche Ausgestaltung des Rohrs 70 des Rohrkühlers 65 Dichtigkeitsprobleme des Rohrkühlers 65 vermieden. Ferner wird durch die beidseitige Anordnung des Rohrkühlers 65 durch die Rohrabschnitte 90, 95 an der Oberseite 15 und durch die Rohrschlange 85 an der Unterseite 20 eine zuverlässige Entwärmung des Elektronikgehäuses 10 und der Elektronikbaugruppe 55 sichergestellt. Insbesondere kann dadurch die Elektronik 55 unabhängig der konstruktiven Ausgestaltung des Elektronikgehäuses 10 und des Rohrkühlers 65 ausgelegt werden, sodass die Elektronik 55 sowohl auf der zur Unterseite 20 als auch zur Oberseite 15 zugewandten Seite Komponenten 260 aufweisen kann.

Ferner können zur formschlüssigen Verbindung mittels der Befestigungsmittel 175, 215 zusätzlich weitere Befestigungsmittel vorgesehen sein, die den Rohrkühler 65 an dem Elektronikgehäuse 10 verklemmen. Dadurch können erhöhte mechanische Anforderungen zur Fixierung des Rohrkühlers 65 am Elektronikgehäuse 10 erfüllt werden. Auch kann dieses Befestigungsmittel alternativ zu den in den Figuren 4 bis 6 gezeigten Befestigungsmitteln 175, 215 vorgesehen sein.

Durch die vorstehend beschriebene Vorrichtung 170 kann ein Teile- und Montageaufwand für die zweiseitige Kühlung des Elektronikgehäuses 10 reduziert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Vorrichtung (170) mit einem Elektronikgehäuse (10) und einem Rohrkühler (65),
- wobei der Rohrkühler (65) ein einteilig und materialeinheitlich ausgebildetes Rohr (70) aufweist,
- wobei das Rohr (70) mit einem Kühlmittel (80) füllbar ist,
- wobei das Rohr (70) eine Rohrschlange (85), einen ersten Rohrabschnitt (90, 95) und einen ersten Verbindungsabschnitt (100, 105) aufweist,
- wobei der erste Rohrabschnitt (90, 95) mit einer Kühlmittelversorgung zur Zuführung des Kühlmittels (80) verbindbar ist,
- wobei der erste Verbindungsabschnitt (100, 105) den ersten Rohrabschnitt (90, 95) mit einer ersten Seite (155) der Rohrschlange (85) fluidisch verbindet,
- wobei der erste Rohrabschnitt (90, 95) lateral versetzt zu der Rohrschlange (85) angeordnet ist,
- wobei die Rohrschlange (85) und der erste Rohrabschnitt (90, 95) sich auf einer gemeinsamen Seite des ersten Verbindungabschnitts (100) erstrecken,
- wobei der erste Verbindungsabschnitt (100) geneigt gegenüber der Rohrschlange (85) und dem ersten Rohrabschnitt (90, 95) angeordnet ist und/oder gekrümmt von der Rohrschlange (85) zu dem ersten Rohrabschnitt (90, 95) verläuft
- wobei das Elektronikgehäuse (10) eine Oberseite (15) und eine der Oberseite (15) gegenüberliegend angeordnete Unterseite (20) aufweist,
- wobei zwischen dem ersten Rohrabschnitt (90, 95) und der Rohrschlange (85) das Elektronikgehäuse (10) angeordnet ist, derart dass die Rohrschlange (85) entlang der Unterseite (20) und der erste Rohrabschnitt (90) entlang der Oberseite (15) des Elektronikgehäuses (10) verläuft und der erste Verbindungsabschnitt (100, 105) seitlich am Elektronikgehäuse (10) vorbeigeführt ist.

2. Vorrichtung (170) nach Anspruch 1,
- wobei das Rohr (70) einen zweiten Rohrabschnitt (95) und einen zweiten Verbindungsabschnitt (105) aufweist,
- wobei der zweite Verbindungsabschnitt (105) den zweiten Rohrabschnitt (95) mit einer zweiten Seite (160) der Rohrschlange (85) fluidisch verbindet,
- wobei der zweite Rohrabschnitt (95) lateral versetzt zu der Rohrschlange (85) angeordnet ist,
- wobei sich die Rohrschlange (85) und der zweite Rohrabschnitt (95) auf einer gemeinsamen Seite des zweiten Verbindungabschnitts (105) erstrecken,
- wobei der zweite Verbindungsabschnitt (105) geneigt zu der Rohrschlange (85) und dem zweiten Rohrabschnitt (95) angeordnet ist und/oder gekrümmt von der Rohrschlange (85) zu dem zweiten Rohrabschnitt (95) verläuft.

3. Vorrichtung (170) nach Anspruch 1 oder 2,
- wobei die Rohrschlange (85) in einer ersten Haupterstreckungsebene (135) und der erste Rohrabschnitt (95, 95) in einer zweiten Haupterstreckungsebene (140) angeordnet sind zwischen welchen insbesondere das Elektronikgehäuse (10) anordenbar ist,
- wobei die erste Haupterstreckungsebene (135) parallel zur zweiten Haupterstreckungsebene (140) angeordnet ist.

4. Vorrichtung (170) nach Anspruch 3,
- wobei der zweite Rohrabschnitt (95) in der zweiten Haupterstreckungsebene (140) angeordnet ist,
- wobei vorzugsweise der zweite Rohrabschnitt (95) parallel zum ersten Rohrabschnitt (90) angeordnet ist.

5. Vorrichtung (170) nach Anspruch 3 oder 4,
- wobei der erste Verbindungsabschnitt (100) und der zweite Verbindungsabschnitt (105) zumindest abschnittsweise in einer gemeinsamen dritten Haupterstreckungsebene (150) angeordnet sind,
- wobei vorzugsweise der zweite Verbindungsabschnitt (105) in der dritten Haupterstreckungsebene (150) geneigt zu dem ersten Verbindungsabschnitt (100) angeordnet ist.

6. Vorrichtung (170) nach einem der Ansprüche 1 bis 5, wobei der erste Verbindungsabschnitt (100, 105) senkrecht zumindest abschnittweise zu dem ersten Rohrabschnitt (90) und/oder zumindest abschnittweise zu der Rohrschlange (85) angeordnet ist.

7. Vorrichtung (170) nach einem der Ansprüche 1 bis 6,
- wobei die Rohrschlange (85) einen ersten Rohrschlangenabschnitt (120), einen zweiten Rohrschlangenabschnitt (125) und wenigstens einen dritten Rohrschlangenabschnitt (130) aufweist,
- wobei der zweite Rohrschlangenabschnitt (125) den ersten Rohrschlangenabschnitt (120) mit dem dritten Rohrschlangenabschnitt (130) fluidisch verbindet, insbesondere an einer dem ersten Verbindungabschnitt (100) abgewandten Seite des ersten Rohrschlangenabschnitt (120),
- wobei der erste Rohrschlangenabschnitt (120) zumindest abschnittsweise parallel zum dritten Rohrschlangenabschnitt (130) angeordnet ist,
- wobei vorzugsweise der zweite Rohrschlangenabschnitt (125) zumindest abschnittweise rechtwinklig zum ersten und/oder dritten Rohrschlangenabschnitt (120, 130) angeordnet ist.

8. Vorrichtung (170) nach Anspruch 7, wobei der erste Rohrabschnitt (90) und/oder der zweite Rohrabschnitt (95) parallel zu dem ersten Rohrschlangenabschnitt (120) und/oder dem dritten Rohrschlangenabschnitt (130) angeordnet sind.

9. Vorrichtung (170) nach Anspruch 7 oder 8,
- wobei der erste Rohrschlangenabschnitt (120) und der dritte Rohrschlangenabschnitt (130) einen ersten Abstand (a₁) zueinander aufweisen,
- wobei der erste Rohrabschnitt (90) und der zweite Rohrabschnitt (95) einen zweiten Abstand (a₂) zueinander aufweisen,
- wobei der zweite Abstand (a₂) unterschiedlich zu dem ersten Abstand (a₁) ist,
- wobei vorzugsweise der zweite Abstand (a₂) größer als der erste Abstand(a₁) ist.

10. Vorrichtung (170) nach einem der Ansprüche 1 bis 9,
- wobei das Rohr (70) einen Anschlussabschnitt (110, 115) umfasst,
- wobei der Anschlussabschnitt (110, 115) mit dem ersten Rohrabschnitt (90, 95) fluidisch verbunden ist,
- wobei der Anschlussabschnitt (110, 115) in Richtung_zu der von der Rohrschlange (85) abgewandten Seite versetzt zu dem ersten Rohrabschnitt (90, 95) angeordnet ist.

11. Vorrichtung (170) nach einem der Ansprüche 1 bis 10, wobei der Anschlussabschnitt (110, 115) beabstandet zu der Oberseite (15) angeordnet ist.

## Claims

1. Device (170) having an electronics housing (10) and a tube cooler (65),
- wherein the tube cooler (65) has a tube (70) formed in one piece from a single material,
- wherein the tube (70) is fillable with a coolant (80),
- wherein the tube (70) has a tube coil (85), a first tube portion (90, 95) and a first connecting portion (100, 105),
- wherein the first tube portion (90, 95) is connectable to a coolant supply for feeding the coolant (80),
- wherein the first connecting portion (100, 105) fluidically connects the first tube portion (90, 95) to a first side (155) of the tube coil (85),
- wherein the first tube portion (90, 95) is arranged in a laterally offset manner with respect to the tube coil (85),
- wherein the tube coil (85) and the first tube portion (90, 95) extend on a common side of the first connecting portion (100),
- wherein the first connecting portion (100) is arranged in an inclined manner with respect to the tube coil (85) and to the first tube portion (90, 95) and/or extends in a curved manner from the tube coil (85) to the first tube portion (90, 95),
- wherein the electronics housing (10) has a top side (15) and an underside (20) arranged on the opposite side from the top side (15),
- wherein the electronics housing (10) is arranged between the first tube portion (90, 95) and the tube coil (85) such that the tube coil (85) extends along the underside (20) and the first tube portion (90) along the top side (15) of the electronics housing (10) and the first connecting portion (100, 105) is guided laterally past the electronics housing (10).

2. Device (170) according to Claim 1,
- wherein the tube (70) has a second tube portion (95) and a second connecting portion (105),
- wherein the second connecting portion (105) fluidically connects the second tube portion (95) to a second side (160) of the tube coil (85),
- wherein the second tube portion (95) is arranged in a laterally offset manner with respect to the tube coil (85),
- wherein the tube coil (85) and the second tube portion (95) extend on a common side of the second connecting portion (105),
- wherein the second connecting portion (105) is arranged in an inclined manner with respect to the tube coil (85) and to the second tube portion (95) and/or extends in a curved manner from the tube coil (85) to the second tube portion (95).

3. Device (170) according to Claim 1 or 2,
- wherein the tube coil (85) is arranged in a first main plane of extent (135) and the first tube portion (95, 95) is arranged in a second main plane of extent (140), between which in particular the electronics housing (10) is arrangeable,
- wherein the first main plane of extent (135) is arranged parallel to the second main plane of extent (140).

4. Device (170) according to Claim 3,
- wherein the second tube portion (95) is arranged in the second main plane of extent (140),
- wherein preferably, the second tube portion (95) is arranged parallel to the first tube portion (90).

5. Device (170) according to Claim 3 or 4,
- wherein the first connecting portion (100) and the second connecting portion (105) are arranged at least partially in a common third main plane of extent (150),
- wherein preferably, the second connecting portion (105) is arranged in the third main plane of extent (150) in an inclined manner with respect to the first connecting portion (100) .

6. Device (170) according to one of Claims 1 to 5, wherein the first connecting portion (100, 105) is arranged perpendicularly at least partially to the first tube portion (90) and/or at least partially to the tube coil (85).

7. Device (170) according to one of Claims 1 to 6,
- wherein the tube coil (85) has a first tube coil portion (120), a second tube coil portion (125) and at least one third tube coil portion (130),
- wherein the second tube coil portion (125) fluidically connects the first tube coil portion (120) to the third tube coil portion (130), in particular on a side of the first tube coil portion (120) facing away from the first connecting portion (100),
- wherein the first tube coil portion (120) is arranged at least partially parallel to the third tube coil portion (130),
- wherein preferably, the second tube coil portion (125) is arranged at least partially at right angles to the first and/or third tube coil portion (120, 130).

8. Device (170) according to Claim 7, wherein the first tube portion (90) and/or the second tube portion (95) are arranged parallel to the first tube coil portion (120) and/or to the third tube coil portion (130).

9. Device (170) according to Claim 7 or 8,
- wherein the first tube coil portion (120) and the third tube coil portion (130) are at a first spacing (a₁) from one another,
- wherein the first tube portion (90) and the second tube portion (95) are at a second spacing (a₂) from one another,
- wherein the second spacing (a₂) is different than the first spacing (a₁),
- wherein preferably, the second spacing (a₂) is greater than the first spacing (a₁).

10. Device (170) according to one of Claims 1 to 9,
- wherein the tube (70) comprises a connection portion (110, 115),
- wherein the connection portion (110, 115) is fluidically connected to the first tube portion (90, 95),
- wherein the connection portion (110, 115) is arranged in an offset manner with respect to the first tube portion (90, 95) in the direction of the side facing away from the tube coil (85).

11. Device (170) according to one of Claims 1 to 10, wherein the connection portion (110, 115) is arranged in a manner spaced apart from the top side (15).

## Revendications

1. Dispositif (170) muni d'un boîtier électronique (10) et d'un refroidisseur tubulaire (65),
- dans lequel le refroidisseur tubulaire (65) présente un tube (70) réalisé en une seule pièce et en une seule matière,
- dans lequel le tube (70) peut être rempli d'un agent de refroidissement (80),
- dans lequel le tube (70) présente un tuyau flexible tubulaire (85), une première section de tube (90, 95) et une première section de liaison (100, 105),
- dans lequel la première section de tube (90, 95) peut être raccordée à une alimentation en agent de refroidissement pour la fourniture de l'agent de refroidissement (80),
- dans lequel la première section de liaison (100, 105) relie de façon fluidique la première section de tube (90, 95) à un premier côté (155) du tuyau flexible tubulaire (85),
- dans lequel la première section de tube (90, 95) est disposée en décalage latéral par rapport au tuyau flexible tubulaire (85),
- dans lequel le tuyau flexible tubulaire (85) et la première section de tube (90, 95) s'étendent sur un côté commun de la première section de liaison (100),
- dans lequel la première section de liaison (100) est disposée de façon inclinée par rapport au tuyau flexible tubulaire (85) et à la première section de tube (90, 95) et/ou s'étend en courbe du tuyau flexible tubulaire (85) jusqu'à la première section de tube (90, 95),
- dans lequel le boîtier électronique (10) présente un côté supérieur (15) et un côté inférieur (20) disposé à l'opposé du côté supérieur (15),
- dans lequel le boîtier électronique (10) est disposé entre la première section de tube (90, 95) et le tuyau flexible tubulaire (85), de telle manière que le tuyau flexible tubulaire (85) s'étende le long du côté inférieur (20) et que la première section de tube (90) s'étende le long du côté supérieur (15) du boîtier électronique (10) et que la première section de liaison (100, 105) soit menée latéralement devant le boîtier électronique (10) .

2. Dispositif (170) selon la revendication 1,
- dans lequel le tube (70) présente une deuxième section de tube (95) et une deuxième section de liaison (105),
- dans lequel la deuxième section de liaison (105) relie de façon fluidique la deuxième section de tube (95) à un deuxième côté (160) du tuyau flexible tubulaire (85),
- dans lequel la deuxième section de tube (95) est disposée en décalage latéral par rapport au tuyau flexible tubulaire (85),
- dans lequel le tuyau flexible tubulaire (85) et la deuxième section de tube (95) s'étendent sur un côté commun de la deuxième section de liaison (105),
- dans lequel la deuxième section de liaison (105) est disposée de façon inclinée par rapport au tuyau flexible tubulaire (85) et à la deuxième section de tube (95) et/ou s'étend en courbe du tuyau flexible tubulaire (85) jusqu'à la deuxième section de tube (95).

3. Dispositif (170) selon une revendication 1 ou 2,
- dans lequel le tuyau flexible tubulaire (85) est disposé dans un premier plan d'extension principal (135) et la première section de tube (95, 95) est disposée dans un deuxième plan d'extension principal (140) entre lesquels notamment le boîtier électronique (10) peut être disposé,
- dans lequel le premier plan d'extension principal (135) est disposé parallèlement au deuxième plan d'extension principal (140).

4. Dispositif (170) selon la revendication 3,
- dans lequel la deuxième section de tube (95) est disposée dans le deuxième plan d'extension principal (140),
- dans lequel la deuxième section de tube (95) est disposée de préférence parallèlement à la première section de tube (90).

5. Dispositif (170) selon la revendication 3 ou 4,
- dans lequel la première section de liaison (100) et la deuxième section de liaison (105) sont disposées au moins en partie dans un troisième plan d'extension principal commun (150),
- dans lequel la deuxième section de liaison (105) est disposée dans le troisième plan d'extension principal (150) de préférence de façon inclinée par rapport à la première section de liaison (100) .

6. Dispositif (170) selon l'une quelconque des revendications 1 à 5, dans lequel la première section de liaison (100, 105) est disposée perpendiculairement au moins en partie par rapport à la première section de tube (90) et/ou au moins en partie par rapport au tuyau flexible tubulaire (85).

7. Dispositif (170) selon l'une quelconque des revendications 1 à 6,
- dans lequel le tuyau flexible tubulaire (85) présente une première partie de tuyau flexible tubulaire (120), une deuxième partie de tuyau flexible tubulaire (125) et au moins une troisième partie de tuyau flexible tubulaire (130),
- dans lequel la deuxième partie de tuyau flexible tubulaire (125) relie de façon fluidique la première partie de tuyau flexible tubulaire (120) à la troisième partie de tuyau flexible tubulaire (130), en particulier sur un côté de la première partie de tuyau flexible tubulaire (120) situé à l'opposé de la première section de liaison (100),
- dans lequel la première partie de tuyau flexible tubulaire (120) est disposée au moins en partie parallèlement à la troisième partie de tuyau flexible tubulaire (130),
- dans lequel la deuxième partie de tuyau flexible tubulaire (125) est disposée de préférence au moins en partie perpendiculairement à la première et/ou à la troisième partie de tuyau flexible tubulaire (120, 130).

8. Dispositif (170) selon la revendication 7, dans lequel la première section de tube (90) et/ou la deuxième section de tube (95) est/sont disposée(s) parallèlement à la première partie de tuyau flexible tubulaire (120) et/ou à la troisième partie de tuyau flexible tubulaire (130).

9. Dispositif (170) selon la revendication 7 ou 8,
- dans lequel la première partie de tuyau flexible tubulaire (120) et la troisième partie de tuyau flexible tubulaire (130) présentent une première distance (a₁) l'une de l'autre,
- dans lequel la première section de tube (90) et la deuxième section de tube (95) présentent une deuxième distance (a₂) l'une de l'autre,
- dans lequel la deuxième distance (a₂) est différente de la première distance (a₁),
- dans lequel la deuxième distance (a₂) est de préférence plus grande que la première distance (a₁).

10. Dispositif (170) selon l'une quelconque des revendications 1 à 9,
- dans lequel le tube (70) comprend une section de raccordement (110, 115),
- dans lequel la section de raccordement (110, 115) est raccordée de façon fluidique à la première section de tube (90, 95),
- dans lequel la section de raccordement (110, 115) est disposée de façon décalée par rapport à la première section de tube (90, 95) en direction du côté situé à l'opposé du tuyau flexible tubulaire (85).

11. Dispositif (170) selon l'une quelconque des revendications 1 à 10, dans lequel la section de raccordement (110, 115) est disposée à distance du côté supérieur (15).
